(19) Europäisches Patentamt / European Patent Office / Office européen des brevets

(11) **EP 4 653 479 A1**

(12) **EUROPEAN PATENT APPLICATION**
published in accordance with Art. 153(4) EPC

(43) Date of publication:
**26.11.2025 Bulletin 2025/48**

(21) Application number: **24878945.5**

(22) Date of filing: **14.10.2024**

(51) International Patent Classification (IPC):
**C08F 210/16** (2006.01)   **C08F 210/14** (2006.01)
**C08F 210/08** (2006.01)   **C08L 23/08** (2025.01)
**C09J 123/08** (2006.01)   **C09J 7/30** (2018.01)
**C09J 7/10** (2018.01)   **H10F 19/80** (2025.01)

(52) Cooperative Patent Classification (CPC):
Y02E 10/50

(86) International application number:
**PCT/CN2024/124645**

(87) International publication number:
**WO 2025/082301 (24.04.2025 Gazette 2025/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.10.2023 CN 202311329489**

(71) Applicant: **Wanhua Chemical Group Co., Ltd.**
**Yantai, Shandong 264006 (CN)**

(72) Inventors:
• **ZHANG, Jie**
**Yantai, Shandong 264006 (CN)**
• **WANG, Jinqiang**
**Yantai, Shandong 264006 (CN)**
• **WANG, Xinyu**
**Yantai, Shandong 264006 (CN)**

• **YANG, Wen**
**Yantai, Shandong 264006 (CN)**
• **MA, Weilong**
**Yantai, Shandong 264006 (CN)**
• **HUANG, Lingyan**
**Yantai, Shandong 264006 (CN)**
• **TIAN, Qin**
**Yantai, Shandong 264006 (CN)**
• **ZHANG, Yanyu**
**Yantai, Shandong 264006 (CN)**
• **WANG, Lei**
**Yantai, Shandong 264006 (CN)**
• **HE, Yong**
**Yantai, Shandong 264006 (CN)**
• **HUA, Weiqi**
**Yantai, Shandong 264006 (CN)**

(74) Representative: **Potter Clarkson**
**Chapel Quarter**
**Mount Street**
**Nottingham NG1 6HQ (GB)**

(54) **ETHYLENE/ALPHA-OLEFIN COPOLYMER FOR SOLAR CELL ENCAPSULATION ADHESIVE FILM, AND USE THEREOF**

(57) Provided in the present invention are an ethylene/α-olefin copolymer for a solar cell encapsulation adhesive film, and the use thereof. Using the ethylene/α-olefin copolymer provided in the present invention in a solar cell encapsulation adhesive film can give consideration to both a relatively high vulcanization reaction speed and good anti-PID performance of the solar cell encapsulation adhesive film. The ethylene/α-olefin copolymer for a solar cell encapsulation adhesive film satisfies the following conditions (a) to (c): (a) under an angular frequency condition of 0.1-500 rad/s, the characteristic relaxation time at 190°C is 200.0-500.0 milliseconds; (b) the weight-average molecular weight is 20,000-200,000 g/mol, the density is 0.850 to 0.910 g/cc; and (c) the molecular weight distribution is 1.5-3.

EP 4 653 479 A1

**Description**

**TECHNICAL FIELD**

The present invention relates to the technical field of solar cell encapsulation film, specifically to an ethylene/$\alpha$-olefin copolymer for solar cell encapsulation film and use thereof.

**BACKGROUND OF THE INVENTION**

As one of the most competitive forms of new energy, photovoltaic power generation is still expected to expand rapidly in the future. The corresponding encapsulation film materials ethylene-vinyl acetate (EVA) and ethylene/$\alpha$-olefin copolymer (POE) account for about 7%, a not high proportion, of the total cost of photovoltaic modules, but they are key factors determining the quality and lifespan of photovoltaic module products. Once the film and backsheet of the cell module start to turn yellow and crack, the cell is prone to premature scrapping. Photovoltaic modules are prone to generate wet leakage current path among encapsulation material, backsheet, glass and frame when used in high-voltage environments for a long time, such that a large amount of charge accumulates on the surface of the solar cell, resulting in significant passivation of the cell surface and a significant decline in the performance of the module, known as PID phenomenon.

The mainstream implementation means for anti-PID film at present stage are: ① Use of polyolefin elastomer POE material with lower permeable rate instead of EVA material; and ②Addition of additional anti-PID additives to the formula. However, both of the above methods have the following drawbacks: the intrinsic anti-PID performance of POE film still needs to be improved; while adding inorganic additives may affect the optical performance of the film, thereby leading to an increase in film haze. Patent applications CN112898920A and CN113234402A as well as patent CN113122164B achieve the purpose of anti-PID of the film by adding inorganic and organic small molecule additives. However, the introduction of additional additives is always accompanied by the problem of additives precipitation, which thus affects the long-periodic usage performance of the encapsulation film. Patent application CN112824466A introduces a crosslinking coagent into the photovoltaic film formulation system, which increases the crosslinking density of the cross-linked encapsulation film and thus enhances its ability to block metal ions, thereby achieving anti-PID effect. However, it still belongs to the optimization of the formulation system and has not improved the encapsulation material itself.

In another important aspect, based on the downstream demand for film processing, how to improve the vulcanization rate of photovoltaic films, thereby shortening the processing time of laminated crosslinking reactions and achieving a greater degree of cost reduction and efficiency improvement, is an urgent problem that needs to be solved in the industry. The existing solution to accelerate the vulcanization rate of POE photovoltaic film is mainly formula optimization or to modify POE particles through silane grafting. Patent application CN116023891A uses chemical grafting-modification to graft silane monomers onto POE macromolecular chains to form a tackifier with high molecular weight, which contributes to crosslinking degree for the film curing through silane crosslinking, improves the crosslinking rate of the film and shortens the curing cycle. Patent application CN115873528A optimizes the crosslinking formula of the film to accelerate the crosslinking rate and improve the production efficiency of modules. Patent application CN116004126A improves the crosslinking properties by changing the layer number and structure of the encapsulation film, thereby comprehensively improving the encapsulation effect of POE applied in modules. Overall, there are few reports and applications based on pure POE particles to improve the crosslinking vulcanization rate and anti-PID performance of photovoltaic films.

In summary, it is necessary to provide a solution that is capable of balancing a relatively fast vulcanization reaction rate and good anti-PID performance without the need for upgrading the formula of solar cell encapsulation film.

**SUMMARY OF THE INVENTION**

The present invention provides an ethylene/$\alpha$-olefin copolymer for solar cell encapsulation film and use thereof. The ethylene/$\alpha$-olefin copolymer provided in the present invention is used in the solar cell encapsulation film, which is capable of balancing the relatively fast vulcanization reaction rate and good anti-PID performance of the solar cell encapsulation film.

For this purpose, the present invention provides the following technical solution:

The first aspect of the present invention provides an ethylene/$\alpha$-olefin copolymer for solar cell encapsulation film, the copolymer satisfies the following conditions (a) to (c):

(a) a characteristic relaxation time at 190 °C under angular frequency conditions of 0.1 rad/s to 500 rad/s ranges from 200.0 milliseconds to 500.0 milliseconds;

(b) a weight-average molecular weight ranges from 20,000 g/mol to 200,000 g/mol, and a density ranges from 0.850 g/cc to 0.910 g/cc; and

(c) a molecular weight distribution ranges from 1.5 to 3.

Preferably, the characteristic relaxation time ranges from 350.0 milliseconds to 500.0 milliseconds, more preferably from 400 milliseconds to 500 milliseconds.

Further, a melt index of the copolymer under 190 °C and 2.16 kg load conditions ranges from 1 g/10min to 50 g/10min.

In some embodiments, the weight-average molecular weight ranges from 40,000 g/mol to 100,000 g/mol.

In some embodiments, the $\alpha$-olefin includes one or more of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.

The second aspect of the present invention provides a method for preparing an ethylene/$\alpha$-olefin copolymer for solar cell encapsulation film as described above, the preparation method includes the following steps:

(S1) polymerizing ethylene and $\alpha$-olefin to obtain a copolymerization product; and

(S2) performing a post-treatment on the copolymerization product to separate out the ethylene/$\alpha$-olefin copolymer that simultaneously satisfies conditions (a) to (c):

(a) the characteristic relaxation time at 190 °C under angular frequency conditions of 0.1 rad/s to 500 rad/s ranges from 200.0 milliseconds to 500.0 milliseconds, preferably from 350.0 milliseconds to 500.0 milliseconds, more preferably from 400 milliseconds to 500 milliseconds;

(b) the weight-average molecular weight ranges from 20,000 g/mol to 200,000 g/mol, and the density ranges from 0.850 g/cc to 0.910 g/cc; and

(c) the molecular weight distribution ranges from 1.5 to 3.

The third aspect of the present invention provides a composition for solar cell encapsulation film, the composition comprises the ethylene/$\alpha$-olefin copolymer described above or the ethylene/$\alpha$-olefin copolymer prepared by the preparation method described above.

Further, the composition further comprises one or more of crosslinking agent, crosslinking coagent, coupling agent and antioxidant.

The fourth aspect of the present invention provides a solar cell encapsulation film, the described encapsulation film is prepared using the described composition.

The fifth aspect of the present invention provides a method for preparing the described solar cell encapsulation film, comprising the following steps:

mixing and melting components in the composition, performing extrusion and casting to form a film, and performing cooling and cutting.

The sixth aspect of the present invention provides a solar cell module, comprising the described solar cell encapsulation film.

The technical solution provided in the present invention has the following beneficial effects:

The ethylene/$\alpha$-olefin copolymer for solar cell encapsulation film provided in the present invention simultaneously satisfies the above-mentioned conditions (a) to (c), has a relatively long characteristic relaxation time, and enables the solar cell encapsulation film to balance the relatively fast vulcanization reaction rate and good anti-PID performance.

## DETAILED DESCRIPTION OF THE SPECIFICATION

In order to facilitate the understanding of the present invention, further explanation will be given below in conjunction with examples. It should be understood that the following examples are only for better understanding of the present invention and do not mean that the present invention is limited to the following examples.

Unless otherwise defined, all technical and scientific terms used herein have the same meanings as those commonly understood by those skilled in the relevant art of the present invention. The term "and/or" that may be used herein includes any combinations and all combinations of one or more related listed items.

Experimental steps or conditions not specified in the examples may be carried out according to the corresponding conventional experimental steps or conditions in this technical field. The reagents or instruments used without specifying the manufacturer are conventional products that can be obtained through commercial purchase.

The ethylene/$\alpha$-olefin copolymer for solar cell encapsulation film provided in the present invention simultaneously satisfies the following conditions (a) to (c):

(a) the characteristic relaxation time at 190°C under angular frequency conditions of 0.1 rad/s to 500 rad/s is in a range from 200.0 milliseconds to 500.0 milliseconds;

(b) the weight-average molecular weight is in a range from 20,000 g/mol to 200,000 g/mol, and the density is in a range from 0.850 g/cc to 0.910 g/cc; and

(c) the molecular weight distribution is in a range from 1.5 to 3.

The ethylene/$\alpha$-olefin copolymer for solar cell encapsulation film of the present invention has the following features: (a) the characteristic relaxation time at 190°C under angular frequency conditions of 0.1 rad/s to 500 rad/s is greater than or equal to 200.0 milliseconds and less than or equal to 500.0 milliseconds, such as 200.0 milliseconds, 250.0 milliseconds, 300.0 milliseconds, 350.0 milliseconds, 400.0 milliseconds, 450.0 milliseconds, 500.0 milliseconds, etc.; preferably, the characteristic relaxation time is in a range from 350.0 milliseconds to 500.0 milliseconds, and more preferably in a range from 400 milliseconds to 500 milliseconds.

Except for the features of characteristic relaxation time mentioned above, the ethylene/$\alpha$-olefin copolymer for solar cell encapsulation film of the present invention also has the following features (b) and (c) simultaneously: (b) the weight-average molecular weight is in a range from 20,000 g/mol to 200,000 g/mol and the density is in a range from 0.850 g/cc to 0.910 g/cc; and (c) the molecular weight distribution is in a range from 1.5 to 3.

The use of the ethylene/$\alpha$-olefin copolymer with the aforementioned features (a)-(c) simultaneously to prepare a solar cell encapsulation film is capable of balancing the relatively short vulcanization reaction time and good anti-PID performance.

The ethylene/$\alpha$-olefin copolymer for solar cell encapsulation film provided in the present invention has a weight-average molecular weight ($M_w$) of 20,000 to 200,000 g/mol, for example, 40,000 g/mol to 100,000 g/mol, for example, 40,000 g/mol to 90,000 g/mol, and further for example, 45,000 g/mol to 75,000 g/mol.

The ethylene/$\alpha$-olefin copolymer for solar cell encapsulation film provided in the present invention has a density of 0.850 g/cc to 0.910 g/cc, such as a density of 0.850 g/cc, 0.860 g/cc, 0.870 g/cc, 0.880 g/cc, 0.890 g/cc, 0.900 g/cc, 0.905 g/cc, 0.910 g/cc, etc.

The ethylene/$\alpha$-olefin copolymer for solar cell encapsulation film provided in the present invention has a molecular weight distribution (PDI) of 1.5 to 3, such as a molecular weight distribution of 1.5, 1.8, 2.0, 2.2, 2.4, 2.6, 2.8, etc., and further for example, a molecular weight distribution of 2.1 to 2.8.

In addition, the ethylene/$\alpha$-olefin copolymer for solar cell encapsulation film provided in the present invention may have a melt index (MI) of 1 g/10min to 50 g/10min under 190 °C and 2.16 kg load conditions, such as a melt index of 1g/10min, 2 g/10min, 3 g/10min, 5 g/10min, 10g/10min, 15 g/10min, 17 g/10min, 20 g/10min, 25 g/10min, 30 g/10min, 40 g/10min, 45 g/10min, 50 g/10min, etc.; for example, a melt index of 2 g/10 min to 40 g/10 min, for example, a melt index of 2 g/10 min to 20 g/10 min, and further for example, a melt index of 3 g/10 min to 17 g/10 min.

The ethylene/$\alpha$-olefin copolymer of the present invention may be a random polymer or a block polymer, wherein the $\alpha$-olefin is derived from the $\alpha$-olefin acting as a comonomer, and the $\alpha$-olefin for example may include a mixture of one or more of propylene, 1-butene, 1-pentene, 4-methyl-1-pentene, 1-hexene, 1-heptene, 1-octene, 1-nonene, 1-decene, 1-undecene, 1-dodecene, 1-tetradecene, 1-hexadecene and 1-eicosene.

Characteristic relaxation time refers to the time which takes to restore the equilibrium state of stress in a polymer after applying constant deformation to the polymer. The characteristic relaxation time is related to the entanglement structure of polymer chains. If the polymer has long-chain branches, as the branch-chain structure increases, the degree of chain entanglement increases, thereby resulting in a prolonged characteristic relaxation time of the polymer. At the same time, due to the increased degree of chain entanglement, the free volume of polymer chains is increased, thus making this part of the polymer more prone to solvation in solvents, thereby enhancing its solubility. Therefore, it has the ability to separate in practical production and applications, that is, polymers with target features may be obtained through dissolution, precipitation and separation.

The present invention further provides a method for preparing the ethylene/$\alpha$-olefin copolymer for solar cell encapsulation film. The ethylene/$\alpha$-olefin copolymer provided in the present invention can be prepared using a preparation method comprising the following steps: (S1) polymerizing ethylene and $\alpha$-olefin to obtain an ethylene/$\alpha$-olefin copolymerization product; and (S2) performing a post-treatment on the copolymerization product to separate out the ethylene/$\alpha$-olefin copolymer that simultaneously satisfies conditions (a) to (c):

(a) the characteristic relaxation time at 190 °C under angular frequency conditions of 0.1 rad/s to 500 rad/s is in a range from 200.0 milliseconds to 500.0 milliseconds, preferably in a range from 350.0 milliseconds to 500.0 milliseconds, more preferably in a range from 400.0 milliseconds to 500.0 milliseconds;

(b) the weight-average molecular weight is in a range from 20,000 g/mol to 200,000 g/mol, and the density is in a range from 0.850 g/cc to 0.910 g/cc; and

(c) the molecular weight distribution is in a range from 1.5 to 3.

In some embodiments, performing a post-treatment on the copolymerization product in step (S2) specifically includes the following steps:

(S2a) first dissolving the prepared copolymerization product in a first good solvent, and then adding the resulting solution to a first poor solvent for precipitation separation to obtain a first liquid-phase portion, removing the solvent from the first liquid-phase portion to obtain the desired product. Further, step (S2b) can be carried out as follows: dissolving the precipitation portion obtained by the precipitation separation in step (S2a) in a second good solvent, and then adding the resulting solution to a second poor solvent for precipitation separation to obtain a second liquid-phase portion, removing the solvent from the second liquid-phase portion to obtain the desired product.

**Step (S1):**

Step (S1) is a step of preparing ethylene/$\alpha$-olefin copolymerization products by polymerizing ethylene and a-olefin.

In step (S1), specifically, solution polymerization may be used, as a reference example, for example, step (S1) may include the following steps: by using the method of solution polymerization in a reactor, organic solvents and a-olefins are introduced into the reactor at the desired reaction temperature, the main catalyst and co-catalyst are added into the reactor, and ethylene gas is introduced into the reactor for reaction to obtain a reactant solution. Wherein, the polymerization monomers ($\alpha$-olefins and/or ethylene) can be fed in a form of single-step feeding or multi-step feeding to control polymer indicator parameters, such as weight-average molecular weight, molecular weight distribution, $\alpha$-olefin copolymer content, etc. After removing the solvent from the obtained reactant solution, the ethylene/$\alpha$-olefin copolymerization product is obtained. Wherein, the reactors used may be conventional reactors in the art, such as annular reactor, isothermal reactor, stirred tank reactor, batch reactor, circulating tubular reactor, etc. The reactors may include one or more reactors in parallel, series and/or any other forms of combination. The reaction may be carried out continuously or intermittently.

Further, the organic solvent used for the polymerization reaction in step (S1) may be one or more of aliphatic solvents and aromatic solvents. Preferably, the aliphatic solvent is selected from one or more of n-butane, isobutane, n-pentane, cyclopentane, n-hexane, cyclohexane, n-heptane, n-octane, n-nonane and their alkylated compounds. Preferably, the aromatic solvent is selected from one or more of benzene, toluene, xylene and their halogenated compounds, wherein the halogenated compound may be a mono-halogenated compound or a poly-halogenated compound.

Further, the main catalyst used for the polymerization reaction in step (S1) is preferably one or more of metallocene catalysts and post-metallocene catalysts, preferably one or more of dimethylsilylene(t-butylamino)(tetramethylcyclopentadienyl) titanium dichloride, bis(methylcyclopentadienyl) zirconium dichloride, bis(1,3-dimethylcyclopentadienyl) zirconium dichloride, cyclopentadienyl-(1,2-dimethoxyethane) zirconium trichloride and dimethylsilylene bis(2-methyl-4-phenylindenyl) zirconium dichloride. Those skilled in the art can determine the specific usage amount of the main catalyst according to the reaction needs. For example, in some embodiments, the usage amount of main catalyst relative to the usage amount of solvent in the reaction system may be 1$\mu$mol/L to 20 $\mu$mol/L.

Further, the co-catalyst used for the polymerization reaction in step (S1) is preferably at least one of alkyl aluminum, organic boron compounds and alkyl aluminoxane, preferably one or more of methylaluminoxane, modified methylaluminoxane, ethylaluminoxane, trimethylaluminium, triethylaluminium, triisobutylaluminium and tris(pentafluorophenyl)boron compounds. Wherein, the molar ratio of aluminium in the co-catalyst to metal atoms in the main catalyst may be (1-1000):1, and the molar ratio of boron in the co-catalyst to metal atoms in the main catalyst may be (0-5):1.

Further, in step (S1), the reaction temperature, for example, is in a range from 100 °C to 210 °C, for example, is in a range from 120 °C to 210 °C, and the reaction pressure, for example, is in a range from 20 bar to 100 bar.

**Steps (S2a) and (S2b):**

Steps (S2a) and (S2b) are steps for preparing and obtaining the ethylene/$\alpha$-olefin copolymer for solar cell encapsulation film provided in the present invention by performing a post-treatment on the ethylene/$\alpha$-olefin copolymer-ization product obtained in step (S1).

In step (S2a), the first good solvent used refers to a solvent that can completely dissolve the copolymerization product in step (S1). In step (S2b), the second good solvent used refers to the solvent that can completely dissolve the precipitation portion obtained in step (S2a). Specifically, the first good solvent and the second good solvent may be one or more of aliphatic solvents and aromatic solvents, respectively. Preferably, the aliphatic solvent is selected from one or more of n-butane, isobutane, n-pentane, cyclopentane, n-hexane, cyclohexane, n-heptane, n-octane, n-nonane and their alkylated compounds. Preferably, the aromatic solvent is selected from one or more of benzene, toluene, xylene and their halogenated compounds, wherein the halogenated compound may be a mono-halogenated compound or a poly-halogenated compound. The dissolution operation using the first good solvent or the second good solvent may be carried out under conditions of 60 °C to 140 °C, and the dissolution operation may be carried out under stirring. When dissolving with the first good solvent, the usage mass ratio of the copolymerization product to the solvent, for example, is 1:3 to 1:8. When dissolving with the second good solvent, the usage mass ratio of the aforementioned precipitation portion to the solvent, for example, is 1:3 to 1:8.

In step (S2a), the first poor solvent used may be an alcohol with 2-20 carbon atoms. Preferably a mixture of one or more of ethanol, ethylene glycol, n-propanol, glycerol, n-butanol, neopentyl alcohol, 1,6-hexanediol, n-octanol, n-decanol, dodecanol, tetradecanol and hexadecanol. The usage amount of the first poor solvent may be 1-5 times the mass of the first good solvent that completely dissolved with the polymer. The conditions for precipitation separation using the first poor solvent may comprise, for example, carrying out at room temperature or 18 °C to 22 °C, gradually adding the first poor solvent to a solution of the first good solvent that completely dissolved with the polymer, and continuously stirring (at a rotational rate of, for example, 200 rpm to 400 rpm) until the polymer precipitate no longer precipitates in the solution. Afterwards, the polymer precipitate in the solution is filtered and separated, and then the solution portion is evaporated to remove the solvent to obtain the ethylene/α-olefin copolymer for solar cell encapsulation film provided in the present invention.

The second poor solvent used in step (S2b) may be a mixed solution of alcohol solvents and ketone solvents. Wherein the alcohol solvent may be an alcohol with 2-20 carbon atoms, preferably a mixture of one or more of ethanol, ethylene glycol, n-propanol, glycerol, n-butanol, neopentyl alcohol, 1,6-hexanediol, n-octanol, n-decanol, dodecanol, tetradecanol and hexadecanol. The ketone solvent preferably is a mixture of one or more of dimethyl ketone, diethyl ketone, butanone, methyl isobutyl ketone, valerophenone, 3-methyl-2-octanone, methyl n-nonanone, methyl phenyl hexanone, bicyclo[3.3.1] nonane-3,7-dione, dimethylcyclohexanedione, 2,2,6-trimethyl-1,4-cyclohexanedione, diphenylethanedione, 3-methyl-2,4-nonanedione, 1-phenyl-2,4-pentanedione and 2,4-decanedione. Preferably, the mass ratio of alcohol solvents to ketone solvents may be (4-10):1. The usage amount of the second poor solvent may be 1-5 times the mass of the second good solvent that completely dissolved with the polymer. In step (S2b), the conditions for precipitation separation may comprise: carrying out at room temperature or 18°C to 22 °C, gradually adding the second poor solvent to a solution of the second good solvent that completely dissolved with the polymer, and continuously stirring (at a rotational rate of, for example, 200 rpm to 400 rpm) until the polymer precipitate no longer precipitates in the solution. Afterwards, the polymer precipitate in the solution is filtered and separated, and then the solution portion is evaporated to remove the solvent to obtain the ethylene/α-olefin copolymer for solar cell encapsulation film provided in the present invention.

The ethylene/α-olefin copolymer for solar cell encapsulation film satisfying conditions (a) to (c) of the present invention can be obtained through step (S2a) or step (S2b) by treating the precipitation portion of step (S2a).

The present invention further provides a composition for solar cell encapsulation film, the composition comprises said ethylene/α-olefin copolymer for solar cell encapsulation film or the ethylene/α-olefin copolymer for solar cell encapsulation film prepared by said preparation method. Specifically, this ethylene/α-olefin copolymer simultaneously satisfies the following conditions (a) to (c):

(a) the characteristic relaxation time at 190 °C under angular frequency conditions of 0.1 rad/s to 500 rad/s is in a range from 200 milliseconds to 500 milliseconds, preferably in a range from 350.0 milliseconds to 500.0 milliseconds, and more preferably in a range from 400 milliseconds to 500 milliseconds:

(b) the weight-average molecular weight is in a range from 20,000 g/mol to 200,000 g/mol, and the density is in a range from 0.850 g/cc to 0.910 g/cc; and

(c) the molecular weight distribution is in a range from 1.5 to 3.

The specific contents of the ethylene/α-olefin copolymer in the above-mentioned composition can refer to the corresponding description of the ethylene/α-olefin copolymer for photovoltaic encapsulation film provided in the present invention, and will not be repeated here.

The above-mentioned composition adopts the ethylene/α-olefin copolymer for photovoltaic encapsulation film provided in the present invention, which can significantly shorten its vulcanization reaction time and endow the obtained encapsulation film with excellent anti-PID performance.

The composition for solar cell encapsulation film may also include other components commonly added in the art, specifically, such as one or more of crosslinking agent, crosslinking coagent, coupling agent and antioxidant. Of course, it may also include other additional components allowed to be added in the art.

Further, the crosslinking agent may be a peroxide-based crosslinking agent, including but not limited to one or a combination of more of the following compounds: tert-butylperoxy isopropyl carbonate, 2,5-dimethyl-2,5-di(tert-butylperoxy)hexane, 1,1-di(tert-butylperoxy)-3,3,5-trimethylcyclohexane, 1,1-di(tert-pentylperoxy)-3,3,5-trimethylcyclohexane, 1,1-di(tert-pentylperoxy)-3,3,5-trimethylcyclohexane, 1,1-di(tert-pentylperoxy)cyclohexane, 1,1-di(tert-butylperoxy)cyclohexane, 2,2-di(tert-butylperoxy)butane, tert-butylperoxy 2-ethylhexyl carbonate, tert-amylperoxy 2-ethylhexyl carbonate, tert-amylperoxy carbonate, tert-butylperoxy-3,5,5-trimethyl hexanoate. Based on 100 parts by weight of ethylene/α-olefin copolymer, the usage amount of the crosslinking agent may be 0.1 parts to 5 parts by weight, preferably 0.5 parts to 2 parts by weight.

Furthermore, the crosslinking coagent may be one or a combination of more of multifunctional acrylic ester substances, including but not limited to one or a combination of more of the following substances: triallyl isocyanurate, trimethylolpropane triacrylate, trihydroxymethylpropyl trimethylacrylate, pentaerythritol triacrylate, tris(2-hydroxyethyl) isocyanurate triacrylate, ethoxylated trimethylolpropane triacrylate, propoxylated trimethylolpropane triacrylate, ethoxylated glyceryl triacrylate, propoxylated glyceryl triacrylate, pentaerythritol tetraacrylate, ethoxylated pentaerythritol tetraacrylate, trimethylolpropane tetraacrylate, di(trimethylolpropane) tetraacrylate, di(trimethylolpropane) tetramethacrylate, propoxylated pentaerythritol tetraacrylate, tricyclodecanedimethanol diacrylate, propoxylated neopentyl glycol diacrylate, ethoxylated bisphenol A diacrylate, ethoxylated bisphenol A dimethacrylate, 2-butyl-2-ethyl-1,3-propanediol diacrylate, diethylene glycol dimethacrylate, triethylene glycol dimethacrylate and polyethylene glycol dimethacrylate. Based on 100 parts by weight of ethylene/$\alpha$-olefin copolymer, the usage amount of the crosslinking coagent may be 0.1 parts to 5 parts by weight, preferably 0.1 parts to 2 parts by weight.

Further, the coupling agent may be a silane-based coupling agent, including but not limited to one or a combination of more of the following compounds: $\gamma$-methacryloxy propyl trimethoxysilane, $\gamma$-chloropropylmethoxysilane, vinyl ethoxysilane, $\gamma$-(2,3-epoxypropoxy)propyltrimethoxysilane, tris($\beta$-methoxyethoxy)(vinyl)silane, $\gamma$-methacryloxy propyl trimethoxysilane, vinyltriacetoxysilane, $\gamma$-glycidoxypropyltrimethoxysilane, 3-(trimethoxysilyl)propyl-2-methyl-2-acrylate, anilinomethyltriethoxysliane and octyltrimethoxysilane. Based on 100 parts by weight of ethylene/$\alpha$-olefin copolymer, the usage amount of the coupling agent may be 0.1 parts to 3 parts by weight, preferably 0.1 parts to 0.6 parts by weight.

Further, the antioxidant may be one or a combination of more of hindered phenolic antioxidants and phosphate ester antioxidants, including but not limited to one or a combination of more of the following compounds: n-octadecyl-$\beta$-(3,5-di-tert-butyl-4-hydroxyphenyl)-propionate, pentaerythritol-tetra-[$\beta$-(3,5-di-tert-butyl-4-hydroxyphenyl)-propionate], bis(3,5-di-tert-butyl-4-hydroxypropionyl)hydrazine, 2,2'-oxamido-bis[ethyl-3-(3,5-di-tert-butyl-4-hydroxyphenyl)] propionate, N,N'-hexamethylene-bis(3,5-di-tert-butyl-4-hydroxyphenyl)propionamide), 1,3,5-tris (3,5-di-tert-butyl-4-hydroxybenzyl)-1,3,5-triazine-2,4,6(1H,3H,5H)trione, triethylene glycol bis[3-(3-tert-butyl-5-methyl-4-hydroxyphenyl)propionate], 2-methyl-4,6-bis(octylsulfanylmethyl)phenol, tris(2,4-di-tert-butylphenyl) phosphite, bis(2,4-di-tert-butylphenyl) pentaerythritol bis(phosphite) and bis(2,6-di-tert-butyl-4-methylphenyl) pentaerythritol diphosphate. Based on 100 parts by weight of ethylene/$\alpha$-olefin copolymer, the usage amount of the antioxidant may be 0.01 parts to 1 parts by weight, preferably 0.05 parts to 0.5 parts by weight.

In some embodiments, the composition for solar cell encapsulation film, based on 100 parts by weight of ethylene/$\alpha$-olefin copolymer, further comprises: 0.1 parts to 5 parts by weight of crosslinking agent, preferably 0.5 parts to 2 parts by weight; 0.1 parts to 5 parts by weight of crosslinking coagent, preferably 0.1 parts to 2 parts by weight; 0.1 parts to 3 parts by weight of coupling agent, preferably 0.1 parts to 0.6 parts by weight; and 0.01 parts to 1 parts by weight of antioxidant, preferably 0.05 parts to 0.5 parts by weight.

The present invention further provides a solar cell encapsulation film, which is prepared using the composition described above. Specifically, the composition comprises the ethylene/$\alpha$-olefin copolymer for photovoltaic encapsulation film provided in the present invention, and the ethylene/$\alpha$-olefin copolymer simultaneously satisfies the following conditions (a) to (c):

(a) the characteristic relaxation time at 190 °C under angular frequency conditions of 0.1 rad/s to 500 rad/s is in a range from 200 milliseconds to 500 milliseconds, preferably in a range from 350.0 milliseconds to 500.0 milliseconds, and more preferably in a range from 400 milliseconds to 500 milliseconds;
(b) the weight-average molecular weight is in a range from 20,000 g/mol to 200,000 g/mol, and the density is in a range from 0.850 g/cc to 0.910 g/cc; and
(c) the molecular weight distribution is in a range from 1.5 to 3.

The specific contents about the composition and the ethylene/$\alpha$-olefin copolymer can refer to the previous description and will not be repeated here.

The present invention further provides a method for preparing the solar cell encapsulation film as described above, which comprises the following steps: mixing and melting the components in the composition, performing extrusion and casting to form a film, and performing cooling and cutting. Specifically, it may also include a winding process. The specific process operation and process conditions of this preparation method can refer to conventional methods in the art, and there are no special restrictions on this.

The solar cell encapsulation film prepared based on the ethylene/$\alpha$-olefin copolymer for photovoltaic encapsulation film of the present invention is capable of balancing the relatively fast vulcanization reaction rate and good anti-PID performance.

The present invention further provides a solar cell module, which comprises the solar cell encapsulation film as described above.

In the present invention, it is found that, for ethylene/$\alpha$-olefin copolymers with relatively long characteristic relaxation times, the degree of chain entanglement thereof is relatively high, and compared with ethylene/α-olefin copolymers with relatively short characteristic relaxation times, it is easier to form a bulk cross-linked structure in the crosslinking reaction, which helps to accelerate the vulcanization crosslinking reaction, shorten the processing time of downstream film factories using laminating machines in the photovoltaic film application process, and shorten the time required for polyolefin elastomers in the film to undergo vulcanization crosslinking reaction. At the same time, as the degree of chain entanglement increases in the polyolefin elastomer structure, the film more readily forms a more densely crosslinked structure, thereby enhancing the barrier capability of the encapsulation film against metal ions, reducing the migration rate of metal ions to the surface of solar cell and consequently achieving the effect of improving the anti-PID performance of the photovoltaic encapsulation film.

The ethylene/α-olefin copolymer for photovoltaic encapsulation film provided in the present invention is an ethylene/α-olefin copolymer with long characteristic relaxation time, which simultaneously satisfies conditions (a)-(c). The encapsulation film containing this copolymer is capable of balancing a fast vulcanization reaction rate and good anti-PID performance, and can be widely used in the fields of electrical and electronic industries.

The present invention will be described in more detail below with reference to examples. The provided examples are only for exemplary introduction and should not be construed as limiting the scope of the present invention thereto.

**The main raw materials are described as follows:**

Tert-butylperoxy 2-ethylhexyl carbonate, Akzo company, purity>95%;
Triallyl isocyanurate, Acros, purity 98%;
γ-methacryloxy propyl trimethoxysilane, Aladdin, purity 95%;
γ-(2,3-epoxypropoxy)propyltrimethoxysilane, Aladdin, purity 95%;
Bis(2,4-di-tert-butylphenyl) pentaerythritol bis(phosphite), Acros, purity 95%;
n-Octadecyl-β-(3,5-di-tert-butyl-4-hydroxyphenyl)-propionate, ark, purity 95%;
1,1-di(tert-butylperoxy)-3,3,5-trimethylcyclohexane, Acros, purity 95%;
Tert-amylperoxy carbonate, ark, purity 95%;
Trimethylolpropane triacrylate, Aladdin, purity 98%;
Antioxidant 1076, n-Octadecyl-β-(3,5-di-tert-butyl-4-hydroxyphenyl)-propionate, Rianlon Corporation, industrial grade;
Antioxidant 1010, pentaerythritol-tetra-[β-(3,5-di-tert-butyl-4-hydroxyphenyl)-propionate], Rianlon Corporation, industrial grade;
1-Octene, Aladdin, purity 99%;
1-Butene, Aladdin, purity 99%;
1-Hexene, Aladdin, purity 99%;
1-Decene, Aladdin, purity 99%;
Ethylene, Mingju Gas Co. Ltd., purity 99.99%;
Methylaluminoxane, Akzo, 10wt% toluene solution;
Modified methylaluminoxane (MMAO-3A), Nouryon, 7wt% toluene solution.
Dimethylsilylene bis(2-methyl-4-phenylindenyl) zirconium dichloride, Jiangsu Sinocompound Catalyst Co., Ltd., purity 98%;
Dimethylsilylene (t-butylamino)(tetramethylcyclopentadienyl) titanium dichloride, Suzhou Yuanqi Material Technology Co., Ltd., purity 98%;
Bis(methylcyclopentadienyl) zirconium dichloride, Meryer (Shanghai) Biochemical Technology Co., Ltd., purity 97%;
Bis(1,3-dimethylcyclopentadienyl) zirconium dichloride, Baoji Funuokang Industrial Co., Ltd., purity>95%;
n-heptane, Shanghai Aladdin Biochemical Technology Co., Ltd., purity>99.5%;
n-octane, Shanghai Aladdin Biochemical Technology Co., Ltd., purity>99.5%;
Methyl phenyl hexanone, Jinan Hongly Chemical Industry Co., Ltd., purity>99%;
Bicyclo(3.3.1)nonane-3,7-dione, Zhengzhou Huiju Chemical Co., Ltd., purity 98%;
3-methyl-2-octanone, Shanghai Haohong Biomedical Technology Co., Ltd., purity>98%;
1-Phenyl-2,4-pentanedione, Beijing Ouhe Technology Co., Ltd., purity>98%;
Alkane solvent, Tianjin Tairong Chemical Trading Co., Ltd., industrial grade;
Ethanol, Tianjin Tairong Chemical Trading Co., Ltd., industrial grade;
PERC battery, Tongwei Co., Ltd., 182 Bifacial Solar Cell.

**Instruments, devices and testing methods:**

The extruder is a single screw extruder (L/D=35) with a screw diameter of 30 mm; Characteristic relaxation time tester: ARES-G2 rheometer from TA company. Under conditions of 190 °C, angular frequency of 0.1 rad/s to 500 rad/s and 5% strain, the complex viscosity is obtained according to the variation of stress of the copolymer with angular frequency, and the characteristic relaxation time $\lambda$ is calculated by fitting using the following Carreau-Yasuda equation.

$$\eta(\gamma)= \eta_\infty+(\eta_0-\eta_\infty)[\,1+(\lambda\gamma)^\alpha]^{(n-1)/\alpha}$$

$\eta\,(\gamma)$: viscosity, unit Pa·s
$\eta\infty$: infinite viscosity, unit Pa·s
$\eta_0$: zero shear viscosity, unit Pa·s
$\lambda$: relaxation time, unit s
$\gamma$: shear rate, unit $s^{-1}$
$\alpha$: material constant, a dimensionless parameter that describes the transition of viscosity from Newtonian area to non-Newtonian area; for the Carreau model, $\alpha$=2;
n: shear thinning index.

PID aging equipment: Shanghai Zealwe Technology Co., Ltd., environmental box, model EW-EC03-PID02-021220.

PID performance testing: anti-PID performance experiments are performed on the prepared double glass photovoltaic modules under 96h-85°C/85RH/-1500V conditions;

PID power testing equipment used for testing anti-PID attenuation: Nanjing Lixite Optoelectronics Technology Co., Ltd., model LXT-CELL;

Testing of characteristic vulcanization times Ts1 and Ts2: the characteristic vulcanization times Ts1 and Ts2 of the copolymer are tested using a rotator-less vulcameter (alpha, MDR) under the conditions of 145 °C for 15 minutes.

Melt index of the copolymer is measured using a melt index meter (CEAST melt index meter, Italy), adopting the national standard GB/T 3682.1-2018 method, at 190 °C under a 2.16 kg load, by weighing the mass of extrudate every 6 seconds, conducting 5 parallel operations, taking the average value and converting to the mass of extrudate per 10 minutes which is expressed in g/10min.

The weight-average molecular weight ($M_w$) and molecular weight distribution (PDI) of the copolymer are measured by high temperature gel permeation chromatography (GPC, Agilent PL-GPC 220, USA). The dissolution temperature of the sample is 160 °C, and the mobile phase is 1,2,4-trichlorobenzene containing 500 ppm BHT (2,6-di-tert-butyl-p-cresol) at a flow rate of 1 mL/min. A monodisperse polystyrene standard sample with a K value of $1.016\times10^{-4}$ and a $\alpha$ value of 0.7220 (the $M_w$ values are 3.1 kg/mol, 9.6 kg/mol, 27.8 kg/mol, 70.5 kg/mol, 187.7 kg/mol, 729.5 kg/mol, 2189.0 kg/mol and 3507.0 kg/mol, successively) is used for universal calibration. The K value and $\alpha$ value of the ethylene/$\alpha$-olefin copolymer (sample to be tested) are $4.416\times10^{-4}$ and 0.7250, respectively.

The density of the copolymer is measured using a densitometer (METTLER TOLEDO densitometer) according to ASTM-D792.

**Preparation of ethylene/$\alpha$-olefin copolymer:**

**Preparation of ethylene-octene copolymer A:** In a 2.0 L continuous process reactor, hexane solvent was injected at 4.50 kg/h and 1-octene was injected at 2.91 kg/h, with the reactor temperature controlled at 150 °C. Dimethylsilylene bis(2-methyl-4-phenylindenyl) zirconium dichloride (0.35 $\mu$mol/min, main catalyst) and a toluene solution of methylaluminoxane with a concentration of 10 wt% (3.5 $\mu$mol/min, co-catalyst) were injected into the reactor simultaneously. Then, ethylene was introduced into the reactor at 1.38 kg/h, and continuous operation was performed under a controlled pressure of 60 bar. After running smoothly (with stable system temperature and pressure), reaction solution was taken continuously in about 2 hours, and the solvent was removed from the reaction solution by evaporation to obtain the polymerization product.

The obtained polymerization product was dissolved completely with n-heptane solvent under stirring at 80 °C to obtain a polymer solution, wherein the usage mass ratio of the polymerization product to solvent was 1:5. After the temperature dropped to room temperature, the polymer solution was added dropwise into ethanol while stirring, where the mass ratio of the polymer solution to ethanol was 1:1. During the dropwise addition process, precipitation occurred. After the dropwise addition was completed, the liquid phase portion was evaporated to remove the solvent and dried in a vacuum oven at 60 °C to a constant weight to obtain ethylene-octene copolymer A. The characteristic relaxation time was measured to be 492.2 milliseconds.

**Preparation of ethylene-octene copolymer B:** The preparation process follows that of ethylene-octene copolymer A. The difference was that the precipitate portion obtained by dropwise adding the polymer solution into ethanol is taken out, and the precipitate portion was completely dissolved in n-heptane under stirring at 80 °C, wherein the mass ratio of the precipitate portion to n-heptane was 1:6. After the temperature dropped to room temperature, the obtained dissolved solution was added dropwise into a mixed solvent of ethanol and methyl phenyl hexanone in a mass ratio of 6:1 and stirred simultaneously, where the mass ratio of the dissolved solution to the mixed solvent was 1:1. After the dropwise addition was completed, the liquid phase portion was evaporated to remove the solvent and dried in a vacuum oven at 60 °C to a constant weight to obtain ethylene-octene copolymer B. The characteristic relaxation time was measured to be 210.3 milliseconds.

**Preparation of ethylene-butene copolymer C:** In a 2.0 L continuous process reactor, n-octane solvent was injected at 5.0 kg/h and 1-butene was injected at 2.67 kg/h, with the reactor temperature controlled at 146 °C. Dimethylsilyene(t-butylamido)(tetramethyl cyclopentadienyl)titanium dichloride (0.48 μmol/min, main catalyst) and a toluene solution of methylaluminoxane with a concentration of 10 wt% (48 μmol/min, co-catalyst) were injected into the reactor simultaneously. Then, ethylene was introduced into the reactor at 1.55 kg/h and continuous operation was performed under controlled pressure of 40 bar. After running smoothly (with stable system temperature and pressure), reaction solution was taken continuously in about 2 hours, and the solvent was removed from the reaction solution by flash evaporation to obtain the polymerization product.

The obtained polymerization product was dissolved completely with n-heptane solvent under stirring at 100°C to obtain a polymer solution, wherein the usage mass ratio of the polymerization product to solvent was 1:5. After the temperature dropped to room temperature, the polymer solution was added dropwise into ethanol while stirring, where the mass ratio of the polymer solution to ethanol was 1:1. During the dropwise addition process, precipitation occurred. After the dropwise addition was completed, the liquid phase portion was evaporated to remove the solvent and dried in a vacuum oven at 60 °C to a constant weight to obtain ethylene-butene copolymer C. The characteristic relaxation time was measured to be 387.5 milliseconds.

**Preparation of ethylene-butene copolymer D:** The preparation process follows that of ethylene-butene copolymer C. The difference was that the precipitate portion obtained by dropwise adding the polymer solution into ethanol was taken out, and the precipitate portion was completely dissolved in n-heptane at 120 °C under stirring, wherein the mass ratio of the precipitate portion to n-heptane was 1:5. After the temperature dropped to room temperature, the obtained dissolved solution was added dropwise into a mixed solvent of ethanol and 3-methyl-2-octanone in a mass ratio of 8:1 and stirred simultaneously, where the mass ratio of the dissolved solution to the mixed solvent was 1:2. After the dropwise addition was completed, the liquid phase portion was taken to remove the solvent and dried in a vacuum oven at 60 °C to a constant weight to obtain ethylene-butene copolymer D. The characteristic relaxation time was measured to be 240.4 milliseconds.

**Preparation of ethylene-hexene copolymer E:** In a 2L batch reaction kettle, the temperature was raised to 160 °C through an oil bath, and a vacuum pump was connected to the reaction kettle pipe to remove water steam and oxygen. After 2 hours, the stirring rate was set to 500 rpm, and 800 mL of n-heptane and 300 ml of 1-hexene were added and stirred at 80 °C. Meanwhile, bis(methylcyclopentadienyl) zirconium dichloride (4 μmol) and a toluene solution of 2mol/L methylaluminoxane (2mL) were added into the reactant solution. Ethylene was introduced into the reaction kettle until the pressure stabilizes at 4 MPa. After 10 minutes of polymerization, the ethylene pressure was released and the solvent was removed under vacuum to obtain the polymerization product.

The obtained polymerization product was stirred and mixed with n-heptane at 80 °C until the polymerization product was completely dissolved, wherein the mass ratio of the polymerization product to n-heptane was 1:5. After the temperature dropped to room temperature, the obtained polymer solution was added dropwise into ethanol while stirring, where the mass ratio of the polymer solution to ethanol was 1:1. During the dropwise addition process, precipitation occurred. After the dropwise addition was completed, the liquid phase portion was taken to remove the solvent, and then dried in a vacuum oven at 60 °C to a constant weight to obtain ethylene-hexene copolymer E. The characteristic relaxation time was measured to be 320.1 milliseconds.

**Preparation of ethylene-hexene copolymer F:** The preparation process follows that of ethylene-hexene copolymer E. The difference was that the precipitate portion obtained by dropwise adding the polymer solution into ethanol was taken out, and the precipitate portion was mixed with n-heptane under stirring at 80 °C until it was completely dissolved, wherein the mass ratio of the precipitate portion to n-heptane was 1:6. After the temperature dropped to room temperature, the obtained dissolved solution was added dropwise into a mixed solvent of ethanol and 1-phenyl-2,4-pentanedione in a mass ratio of 7:1 and stirred simultaneously, where the mass ratio of the dissolved solution to the mixed solvent was 1:1. After the dropwise addition was completed, the liquid phase portion was taken to remove the solvent and dried in a vacuum oven at 60 °C to a constant weight to obtain ethylene-hexene copolymer F. The characteristic relaxation time was measured to be 202.8 milliseconds.

**Preparation of ethylene-decene copolymer G:** In a 20 L continuous loop tubular reactor, toluene solvent was injected at 40 kg/h and 1-decene was injected at 20 kg/h, with the reactor temperature controlled at 126 °C. Bis(1,3-dimethylcyclopentadienyl) zirconium dichloride (5.0 μmol/min, main catalyst) and a toluene solution of Al modified methylaluminoxane (Nouryon, MMAO-3A) with a concentration of 7 wt% (200 μmol/min, co-catalyst) were injected into the reactor simultaneously. Then, ethylene was introduced into the reactor at 18.5kg/h and continuous operation was performed under a controlled pressure of 45 bar. After running smoothly (with stable system temperature and pressure), reaction solution was taken continuously in about 0.5 hours, and the solvent was removed from the reaction solution through flash evaporation and screw extruder to obtain the polymerization product.

The obtained polymerization product was dissolved completely with n-heptane solvent under stirring at 140 °C to obtain a polymer solution, wherein the usage mass ratio of the polymerization product to solvent was 1:4. After the temperature dropped to room temperature, the polymer solution was added dropwise into ethanol while stirring, where the mass ratio of the polymer solution to ethanol was 1:3. During the dropwise addition process, precipitation occurred. After the dropwise addition was completed, the liquid phase portion was taken to remove the solvent and dried in a vacuum oven at 60 °C to a constant weight to obtain ethylene-decene copolymer G. The characteristic relaxation time was measured to be 498.8 milliseconds.

**Preparation of ethylene-decene copolymer H:** The preparation process follows that of ethylene-decene copolymer G. The difference was that the precipitate portion obtained by dropwise adding the polymer solution into ethanol was taken out, and the precipitate portion was mixed with n-heptane under stirring at 80 °C until it was completely dissolved, wherein the mass ratio of the precipitate portion to n-heptane was 1:4. After the temperature dropped to room temperature, the obtained dissolved solution was added dropwise into a mixed solvent of ethanol and bicyclo(3.3.1) nonane-3,7-dione in a mass ratio of 6:1 and stirred simultaneously, where the mass ratio of the dissolved solution to the mixed solvent was 1:1. After the dropwise addition was completed, the liquid phase portion was taken to remove the solvent and dried in a vacuum oven at 60 °C to a constant weight to obtain the ethylene-decene copolymer H. The characteristic relaxation time was measured to be 287.6 milliseconds.

**Preparation of ethylene-octene copolymer I:** it was prepared according to the method of Comparative Example 6 of patent CN113767118B.

**Preparation of ethylene-hexene copolymer J:** it was prepared according to the method of Example 8 of patent US10975173B2.

The physical parameters of the ethylene/α-olefin copolymers produced are shown in Table 1.

**Table 1**

|  | Characteristic relaxation time ms (milliseconds) | Weight-average molecular weight $10^4$ g/mol | Molecular weight distribution PDI | Density g/cc | Melt index g/10min |
|---|---|---|---|---|---|
| Ethylene -octene copolymer A | 492.2 | 6.28 | 2.43 | 0.870 | 5.27 |
| Ethylene -octene copolymer B | 210.3 | 6.64 | 2.33 | 0.872 | 4.95 |
| Ethylene -butene copolymer C | 387.5 | 6.46 | 2.47 | 0.871 | 5.17 |
| Ethylene -butene copolymer D | 240.4 | 6.67 | 2.37 | 0.872 | 5.02 |
| Ethylene -hexene copolymer E | 320.1 | 4.14 | 2.37 | 0.862 | 34.8 |
| Ethylene -hexene copolymer F | 202.8 | 4.23 | 2.32 | 0.864 | 34.5 |
| Ethylene -decene copolymer G | 498.8 | 8.02 | 2.20 | 0.901 | 2.8 |
| Ethylene -decene copolymer H | 287.6 | 8.31 | 2.18 | 0.905 | 2.4 |
| Ethylene -octene copolymer I | 190.2 | 7.9 | 2.20 | 0.901 | 2.8 |
| Ethylene-hexene copolymer J | 632.2 | 5.52 | 2.21 | 0.956 | 8.5 |

## Example 1

9g of tert-butylperoxy 2-ethylhexyl carbonate, 5g of triallyl isocyanurate, 2g of γ-methacryloxy propyl trimethoxysilane, 1g of γ-(2,3-epoxypropoxy) propyltrimethoxysilane, 1g of bis(2,4-di-tert-butylphenyl) pentaerythritol bis(phosphite) and 1g of n-octadecyl-β-(3,5-di-tert-butyl-4-hydroxyphenyl)-propionate were added to 1,000g of ethylene-octene copolymer A (ethylene/α-olefin copolymer).

The above raw materials were heated to 50 °C and mixed evenly. Parameters of the extruder were adjusted. The temperature from the discharge opening to the die head was 80 °C, 90 °C, 90 °C, 90 °C, 90 °C, 95 °C, 95 °C and 95 °C, screw rate was 45 rpm, traction rate was 0.7 rpm, and winding rate was 1.3 rpm. After extrusion, film casting, cooling and cutting as well as winding processes, a solar cell encapsulation film with a film thickness of 0.6mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.

**Example 2**

9g of tert-butylperoxy 2-ethylhexyl carbonate, 5g of triallyl isocyanurate, 2g of $\gamma$-methacryloxy propyl trimethoxysilane, 1g of $\gamma$-(2,3-epoxypropoxy) propyltrimethoxysilane, 1g of bis(2,4-di-tert-butylphenyl) pentaerythritol bis(phosphite) and 1g of n-octadecyl-$\beta$-(3,5-di-tert-butyl-4-hydroxyphenyl)-propionate were added to 1,000g of ethylene-octene copolymer B (ethylene/$\alpha$-olefin copolymer).
The above raw materials were heated to 50 °C and mixed evenly. Parameters of the extruder were adjusted. The temperature from the discharge opening to the die head was 80 °C, 90 °C, 90 °C, 90 °C, 90 °C, 95 °C, 95 °C and 95 °C, screw rate was 45 rpm, traction rate was 0.7 rpm, and winding rate was 1.3 rpm. After extrusion, film casting, cooling and cutting as well as winding processes, a solar cell encapsulation film with a film thickness of 0.6 mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.

**Example 3**

6g of 1,1-di(tert-butylperoxy)-3,3,5-trimethylcyclohexane, 2g of tert-amylperoxy carbonate, 4g of trimethylolpropane triacrylate, 2g of $\gamma$-methacryloxy propyl trimethoxysilane, 1g of $\gamma$-(2,3-epoxypropoxy) propyltrimethoxysilane, 0.1g of antioxidant 1076 and 1g of antioxidant 1010 were added to 1,000g of ethylene-butene copolymer C.
The above raw materials were heated to 50 °C and mixed evenly. Parameters of the extruder were adjusted. The temperature from the discharge opening to the die head was 80 °C, 90 °C, 90 °C, 90 °C, 90 °C, 95 °C, 95 °C and 95 °C, screw rate was 45 rpm, traction rate was 0.7 rpm, and winding rate was 1.3 rpm. After extrusion, film casting, cooling and cutting as well as winding processes, a solar cell encapsulation film with a film thickness of 0.6 mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.

**Example 4**

6g of 1,1-di(tert-butylperoxy)-3,3,5-trimethylcyclohexane, 2g of tert-amylperoxy carbonate, 4g of trimethylolpropane triacrylate, 2g of $\gamma$-methacryloxy propyl trimethoxysilane, 1g of $\gamma$-(2,3-epoxypropoxy) propyltrimethoxysilane, 0.1g of antioxidant 1076 and 1g of antioxidant 1010 were added to 1,000g of ethylene-butene copolymer D.
The above raw materials were heated to 50 °C and mixed evenly. Parameters of the extruder were adjusted. The temperature from the discharge opening to the die head was 80 °C, 90 °C, 90 °C, 90 °C, 90 °C, 95 °C, 95 °C and 95 °C, screw rate was 45 rpm, traction rate was 0.7 rpm, and winding rate was 1.3 rpm. After extrusion, film casting, cooling and cutting as well as winding processes, a solar cell encapsulation film with a film thickness of 0.6mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.

**Example 5**

Example 5 was performed by referring to Example 1, and the difference was that the ethylene/$\alpha$-olefin copolymer usedwas 1,000g of ethylene-hexene copolymer E.

**Example 6**

Example 6 was performed by referring to Example 1, and the difference was that the ethylene/$\alpha$-olefin copolymer used was 1,000g of ethylene-hexene copolymer F.

**Example 7**

Example 7 was performed by referring to Example 3, and the difference was that the ethylene/α-olefin copolymer used was 1,000g of ethylene-decene copolymer G.

**Example 8**

Example 8 was performed by referring to Example 3, and the difference was that the ethylene/α-olefin copolymer used was 1,000g of ethylene-decene copolymer H.

**Comparative Example 1**

6g of 1,1-di(tert-butylperoxy)-3,3,5-trimethylcyclohexane, 2g of tert-amylperoxy carbonate, 4g of trimethylolpropane triacrylate, 2g of γ-methacryloxy propyl trimethoxysilane, 1g of γ-(2,3-epoxypropoxy) propyltrimethoxysilane, 0.1g of antioxidant 1076 and 1g of antioxidant 1010 were added to 1,000g of ethylene-butene copolymer I.
The above raw materials were heated to 50 °C and mixed evenly. Parameters of the extruder were adjusted. The temperature from the discharge opening to the die head was 80 °C, 90 °C, 90 °C, 90 °C, 90 °C, 95 °C, 95 °C and 95 °C, screw rate was 45rpm, traction rate was 0.7 rpm, and winding rate was 1.3 rpm. After extrusion, film casting, cooling and cutting as well as winding processes, a solar cell encapsulation film with a film thickness of 0.6mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.

**Comparative Example 2**

6g of 1,1-di(tert-butylperoxy)-3,3,5-trimethylcyclohexane, 2g of tert-amylperoxy carbonate, 4g of trimethylolpropane triacrylate, 2g of γ-methacryloxy propyl trimethoxysilane, 1g of γ-(2,3-epoxypropoxy) propyltrimethoxysilane, 0.1g of antioxidant 1076 and 1g of antioxidant 1010 were added to 1,000g of ethylene-hexene copolymer J.
The above raw materials were heated to 55 °C and mixed evenly. Parameters of the extruder were adjusted. The temperature from the discharge opening to the die head was 95 °C, 105 °C, 105 °C, 105 °C, 105 °C, 105 °C, 105 °C and 105 °C, screw rate was 42 rpm, traction rate was 0.6 rpm, and winding rate was 1.2 rpm. After extrusion, film casting, cooling and cutting as well as winding processes, a solar cell encapsulation film with a film thickness of 0.6mm was prepared. Subsequently, tempered glass, encapsulation film, crystalline silicon solar cell, encapsulation film and float glass were placed in order from top to bottom, and laminated by a laminating machine at 145 °C to prepare a double glass photovoltaic module.
The test results of the Examples and the Comparative Examples are shown in Table 2.

Table 2

| Performance | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|
| Front-side 96h anti-PID degradation /% | 0.8 | 1.63 | 1.02 | 1.51 | 1.2 | 1.85 | 0.5 | 1.21 | 2.24 | 0.41 |
| Back-side 96h anti-PID degradation /% | 1.64 | 2.47 | 2.15 | 2.36 | 2.11 | 2.75 | 1.6 | 2.18 | 3.17 | 1.2 |
| Vulcanization time Tsl/s | 3.11 | 5.23 | 3.85 | 4.84 | 8.34 | 8.56 | 3.09 | 3.24 | 9.32 | not detected |
| Vulcanization time Ts2/s | 4.67 | 7.83 | 6.02 | 7.07 | 14.80 | 15.01 | 4.52 | 4.68 | not detected | not detected |

The experimental results in Table 2 confirm that using the ethylene/α-olefin copolymer for solar cell encapsulation film of the present invention can significantly shorten the vulcanization time of the encapsulation film and achieve good anti-PID performance compared to the ethylene/α-olefin copolymer used in the comparative examples. The ethylene/α-olefin copolymers used in the comparative examples do not simultaneously meet the conditions (a)-(c) required by the present invention, and it is difficult for the prepared encapsulation films to balance the relatively short vulcanization time and good-anti PID performance, and a good balance between the two performances cannot be achieved.

The present invention provides an ethylene/α-olefin copolymer for solar cell encapsulation film and its composition, wherein the matrix resin thereof has a long characteristic relaxation time, making the molecular structure more prone to chain entanglement. When the molecular chain lengths are similar, the degree of chain entanglement of the polymer itself increases, making it easier to form a bulk crosslinked structure during the lamination crosslinking reaction, thus enabling faster completion of the vulcanization crosslinking reaction and shortening the processing time, manifested as a decrease in characteristic vulcanization times Ts1 and Ts2. Meanwhile, as the degree of chain entanglement increases, the polymer more readily forms a more densely crosslinked structure, thereby enhancing the barrier capability of the encapsulation film against metal ions, and further exhibiting the effect of improving the anti-PID performance of the photovoltaic encapsulation film, manifested as a decrease in front-side 96h anti-PID degradation and back-side 96h anti-PID degradation. The characteristic relaxation time of the matrix resin used in Comparative Example 1 is too short, resulting in significantly poorer vulcanization performance of the prepared film and anti-PID effect of the modules. However, for the matrix resin used in Comparative Example 2, the characteristic relaxation time is too long, the particles are relatively hard as a whole and the density is too high; if the same temperature conditions as in the Examples were used during the casting process, it is found that the particles are difficult to fully plasticize, and an additional increase in temperature is required to fully plasticize the particles, which will reduce production capacity and be unfavorable for downstream subsequent processing. Furthermore, an excessively high particle density causes the resin particles to exhibit more plastomer-like rather than elastomer-like, making it difficult for additives to migrate into the interior of the resin particles during the maturing process, leading to a decrease in the absorption effect of the particle additives, and thereby resulting in a severe decline in vulcanization performance, and almost no crosslinking was found. Further, the particles are relatively hard as a whole and have weak protective effects on the solar cell, thereby the solar cell is prone to hidden crack development during lamination, resulting in a decrease in module production yield.

It is easy to understand that the above examples are only examples for clear illustration and do not mean that the present invention is limited thereto. For those ordinary skilled in the relevant field, other forms of variations or modifications may be made based on the above illustration. It is not necessary and impossible to exhaustively list all embodiments here. The obvious variations or modifications arising from this are still within the scope of protection of the present invention.

## Claims

1. An ethylene/α-olefin copolymer for solar cell encapsulation film, **characterized in that** the copolymer satisfies the following conditions (a) to (c):

   (a) a characteristic relaxation time at 190 °C under angular frequency conditions of 0.1 rad/s to 500 rad/s ranges from 200.0 milliseconds to 500.0 milliseconds;
   (b) a weight-average molecular weight ranges from 20,000 g/mol to 200,000 g/mol, and a density ranges from 0.850 g/cc to 0.910 g/cc; and
   (c) a molecular weight distribution ranges from 1.5 to 3.

2. The ethylene/α-olefin copolymer according to claim 1, **characterized in that** the characteristic relaxation time ranges from 350.0 milliseconds to 500.0 milliseconds, more preferably from 400 milliseconds to 500 milliseconds.

3. The ethylene/α-olefin copolymer according to claim 1, **characterized in that** a melt index of the copolymer under 190 °C and 2.16 kg load conditions ranges from 1 g/10min to 50 g/10min.

4. The ethylene/α-olefin copolymer according to any one of claims 1-3, **characterized in that** the weight-average molecular weight ranges from 40,000 g/mol to 100,000 g/mol.

5. The ethylene/α-olefin copolymer according to any one of claims 1-3, **characterized in that** the α-olefin comprises one or more of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.

6. A method for preparing the ethylene/α-olefin copolymer for solar cell encapsulation film according to any one of claims 1-5, **characterized in that** the method comprises the following steps:

(S1) polymerizing ethylene and α-olefin to obtain a copolymerization product; and
(S2) performing a post-treatment on the copolymerization product to separate out the ethylene/α-olefin copolymer that simultaneously satisfies conditions (a) to (c):

(a) the characteristic relaxation time at 190 °C under angular frequency conditions of 0.1 rad/s to 500 rad/s ranges from 200.0 milliseconds to 500.0 milliseconds, preferably from 350.0 milliseconds to 500.0 milliseconds, more preferably from 400 milliseconds to 500 milliseconds;
(b) the weight-average molecular weight ranges from 20,000 g/mol to 200,000 g/mol, and the density ranges from 0.850 g/cc to 0.910 g/cc; and
(c) the molecular weight distribution ranges from 1.5 to 3.

7.  A composition for solar cell encapsulation film, **characterized in that** the composition comprises the ethylene/α-olefin copolymer according to any one of claims 1-5 or the ethylene/α-olefin copolymer prepared by the method according to claim 6;
preferably, the composition further comprises one or more of crosslinking agent, crosslinking coagent, coupling agent and antioxidant.

8.  A solar cell encapsulation film, **characterized in that** the encapsulation film is prepared using the composition according to claim 7.

9.  A method for preparing the solar cell encapsulation film according to claim 8, **characterized in that**, the method comprises the following steps:
mixing and melting components in the composition, performing extrusion and casting to form a film, and performing cooling and cutting.

10. A solar cell module, comprising the solar cell encapsulation film according to claim 8.

## INTERNATIONAL SEARCH REPORT

| International application No. |
| --- |
| **PCT/CN2024/124645** |

### A. CLASSIFICATION OF SUBJECT MATTER

C08F210/16(2006.01)i; C08F210/14(2006.01)i; C08F210/08(2006.01)i; C08L23/08(2006.01)i; C09J123/08(2006.01)i; C 09J7/30(2018.01)i; C09J7/10(2018.01)i; H01L31/048(2014.01)i

According to International Patent Classification (IPC) or to both national classification and IPC

### B. FIELDS SEARCHED

Minimum documentation searched (classification system followed by classification symbols)

IPC: C08F, C08L, C09J, H01L

Documentation searched other than minimum documentation to the extent that such documents are included in the fields searched

Electronic data base consulted during the international search (name of data base and, where practicable, search terms used)

CNTXT, VCN, VEN, ENTXTC, ENTXT, DWPI, CNKI, WEB OF SCIENCE: 乙烯, 烯烃, 共聚物, 分子量分布, 支链, 密度, 松弛时间, 特征时间, 驰豫时间, 太阳能电池, 封装, 密封, 溶解, 沉淀, 分离, ethylene alpha olefin copolymer, characteristic relaxation time, narrow, molecular weight distribution, MWD, density, solar cell, battery, encapsula+, seal+, packag+, PID, dissolv+, precipitat+, separat+

### C. DOCUMENTS CONSIDERED TO BE RELEVANT

| Category* | Citation of document, with indication, where appropriate, of the relevant passages | Relevant to claim No. |
| --- | --- | --- |
| A | CN 1245513 A (THE DOW CHEMICAL COMPANY) 23 February 2000 (2000-02-23) entire document | 1-10 |
| A | EP 4047051 A1 (LG CHEMICAL LTD.) 24 August 2022 (2022-08-24) entire document | 1-10 |
| A | US 2011218308 A1 (SUMITOMO CHEMICAL CO., LTD.) 08 September 2011 (2011-09-08) entire document | 1-10 |
| A | WO 2016194606 A1 (BRIDGESTONE CORP.) 08 December 2016 (2016-12-08) entire document | 1-10 |
| A | US 2010305292 A1 (SUMITOMO CHEMICAL CO., LTD.) 02 December 2010 (2010-12-02) entire document | 1-10 |
| A | CN 113767118 A (LG CHEMICAL LTD.) 07 December 2021 (2021-12-07) entire document | 1-10 |

☐ Further documents are listed in the continuation of Box C.     ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 November 2024** | **02 January 2025** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/124645**

| Patent document cited in search report | | | Publication date (day/month/year) | Patent family member(s) | | | Publication date (day/month/year) |
|---|---|---|---|---|---|---|---|
| CN | 1245513 | A | 23 February 2000 | DE | 69737458 | D1 | 19 April 2007 |
| | | | | DE | 69737458 | T2 | 05 July 2007 |
| | | | | ES | 2279551 | T3 | 16 August 2007 |
| | | | | CA | 2274746 | A1 | 18 June 1998 |
| | | | | CA | 2274746 | C | 27 March 2007 |
| | | | | EP | 0944669 | A1 | 29 September 1999 |
| | | | | EP | 0944669 | B1 | 07 March 2007 |
| | | | | ATE | 356169 | T1 | 15 March 2007 |
| | | | | AR | 010767 | A1 | 12 July 2000 |
| | | | | NZ | 336307 | A | 30 November 2001 |
| | | | | BR | 9713707 | A | 08 January 2002 |
| | | | | MY | 126398 | A | 29 September 2006 |
| | | | | TW | 496884 | B | 01 August 2002 |
| | | | | AU | 7400598 | A | 03 July 1998 |
| | | | | AU | 740572 | B2 | 08 November 2001 |
| | | | | ZA | 9711155 | B | 11 June 1999 |
| | | | | KR | 20000069448 | A | 25 November 2000 |
| | | | | KR | 100478376 | B1 | 24 March 2005 |
| | | | | WO | 9826000 | A1 | 18 June 1998 |
| | | | | JP | 2001505949 | A | 08 May 2001 |
| | | | | JP | 2009097017 | A | 07 May 2009 |
| | | | | MX | 9905517 | A1 | 01 October 1991 |
| | | | | TH | 53974 | A | 22 November 2002 |
| | | | | US | 2003114595 | A1 | 19 June 2003 |
| | | | | US | 6812289 | B2 | 02 November 2004 |
| | | | | MX | 236425 | B | 03 May 2006 |
| | | | | TH | 47953 | R0 | 08 February 2016 |
| EP | 4047051 | A1 | 24 August 2022 | KR | 20210128320 | A | 26 October 2021 |
| | | | | KR | 102387101 | B1 | 18 April 2022 |
| | | | | EP | 4047051 | A4 | 18 January 2023 |
| | | | | WO | 2021210749 | A1 | 21 October 2021 |
| | | | | IN | 202217029753 | A | 02 September 2022 |
| | | | | US | 2023002597 | A1 | 05 January 2023 |
| | | | | JP | 2023507315 | W | 22 February 2023 |
| | | | | JP | 7418900 | B2 | 22 January 2024 |
| | | | | US | 11884801 | B2 | 30 January 2024 |
| US | 2011218308 | A1 | 08 September 2011 | DE | 112009002715 | T5 | 21 March 2013 |
| | | | | WO | 2010055935 | A1 | 20 May 2010 |
| | | | | KR | 20110084217 | A | 21 July 2011 |
| | | | | US | 8436101 | B2 | 07 May 2013 |
| | | | | CN | 102209734 | A | 05 October 2011 |
| | | | | CN | 102209734 | B | 17 September 2014 |
| | | | | IN | 201103110 | P4 | 31 August 2012 |
| WO | 2016194606 | A1 | 08 December 2016 | JP | 2018125317 | A | 09 August 2018 |
| US | 2010305292 | A1 | 02 December 2010 | JP | 2009149872 | A | 09 July 2009 |
| | | | | JP | 5407300 | B2 | 05 February 2014 |
| | | | | US | 8871885 | B2 | 28 October 2014 |
| | | | | DE | 112008003231 | T5 | 14 October 2010 |
| | | | | WO | 2009069825 | A1 | 04 June 2009 |
| | | | | CN | 101878236 | A | 03 November 2010 |

Form PCT/ISA/210 (patent family annex) (July 2022)

**INTERNATIONAL SEARCH REPORT**
Information on patent family members

International application No.

**PCT/CN2024/124645**

| Patent document cited in search report | | | Publication date (day/month/year) | Patent family member(s) | | | Publication date (day/month/year) |
|---|---|---|---|---|---|---|---|
| | | | | CN | 101878236 | B | 07 May 2014 |
| CN | 113767118 | A | 07 December 2021 | WO | 2021060917 | A1 | 01 April 2021 |
| | | | | JP | 2022519109 | A | 18 March 2022 |
| | | | | US | 2022081501 | A1 | 17 March 2022 |
| | | | | EP | 3909990 | A1 | 17 November 2021 |
| | | | | EP | 3909990 | A4 | 20 April 2022 |
| | | | | KR | 20210037582 | A | 06 April 2021 |
| | | | | KR | 102282283 | B1 | 27 July 2021 |
| | | | | JP | 2022519109 | W | 18 March 2022 |
| | | | | IN | 202117037193 | A | 01 April 2022 |
| | | | | CN | 113767118 | B | 03 January 2023 |
| | | | | SG | 11202108865 | B | 10 November 2023 |
| | | | | SG | 11202108865 | A1 | 29 September 2021 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 112898920 A
- CN 113234402 A
- CN 113122164 B
- CN 112824466 A
- CN 116023891 A
- CN 115873528 A
- CN 116004126 A
- GB 368212018 T
- CN 113767118 B
- US 10975173 B2